# EUROPEAN PATENT SPECIFICATION

(11) **EP 3 550 596 B1**
(45) Date of publication and mention of the grant of the patent: **04.09.2024**
(21) Application number: 18165648.9
(22) Date of filing: 04.04.2018
(51) Int. Cl.: H01L 21/60, B23K 20/00, H01L 23/00

(54) **ARRANGEMENTS AND METHOD FOR PROVIDING A WIRE BOND CONNECTION**
ANORDNUNGEN UND VERFAHREN ZUR BEREITSTELLUNG EINER DRAHTBONDVERBINDUNG
AGENCEMENTS ET PROCÉDÉ POUR FOURNIR UNE CONNEXION A FILS DE LIAISON

(43) Date of publication of application: 09.10.2019
(73) Proprietor: Infineon Technologies AG, 85579 Neubiberg (DE)
(72) Inventor: Eacock, Florian, 33102 Paderborn (DE); Broll, Marian Sebastian, 59494 Soest (DE); Tophinke, Stefan, 33102 Paderborn (DE)
(74) Representative: Westphal, Mussgnug & Partner, Patentanwälte mbB

(56) References cited:
- JP-A- 2013 171 964
- JP-A- H01 296 637
- JP-A- S57 190 328
- US-A1- 2004 217 488
- US-A1- 2005 150 932
- US-A1- 2015 243 534
- US-A1- 2015 380 368
- KOMIYAMA T ET AL: "HIGH-TEMPERATURE THICK AL WIRE BONDING TECHNOLOGY FOR HIGH-POWER MODULES", JAPANESE JOURNAL OF APPLIED PHYSICS, JAPAN SOCIETY OF APPLIED PHYSICS, JP, vol. 41, no. 8, PART 01, 1 August 2002 (2002-08-01), pages 5030 - 5033, XP001162584, ISSN: 0021-4922, DOI: 10.1143/JJAP.41.5030
- BEHRENS TIM: "Novel copper metallization on silicon carbide electronic devices enabling increased packaging lifetime and higher junction-temperatures", 2013 15TH EUROPEAN CONFERENCE ON POWER ELECTRONICS AND APPLICATIONS (EPE), IEEE, 2 September 2013 (2013-09-02), pages 1 - 10, XP032505555, DOI: 10.1109/EPE.2013.6634478

## Description

### TECHNICAL FIELD

The instant disclosure relates to arrangements and to a method for providing a bond connection, in particular for providing a bond connection for electrically connecting elements of a power semiconductor module.

### BACKGROUND

Power semiconductor module arrangements often include a base plate within a housing and at least one substrate is arranged on the base plate. Other power semiconductor module arrangements may solely include a substrate (e.g. Cu-ceramic-Cu substrate) without a base plate. A semiconductor arrangement including a plurality of controllable semiconductor components (e.g., two IGBTs in a half-bridge configuration) is usually arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor components are mounted, for example, on the first metallization layer. The second metallization layer is usually attached to the base plate. Other substrates are known including multiple substrate and metal layers stacked on each other, with buried metal layers acting either as shielding layers or being part of the electronic circuit and electrically connected to other metal layers by means of through contacts. The electrical connections between the semiconductor components and the first metallization layer, between different semiconductor components, between the first metallization layers of different substrates, or between any other elements of the power semiconductor module arrangement often comprise bonding wires. The bonding wire is usually bonded to an electrically conductive surface or bond pad arranged on the component that is to be electrically contacted.

Several different methods for establishing a permanent electrical connection or bond between a bonding wire and an electrically conductive surface are known. Such known method include the so-called wedge bonding, or wedge/wedge bonding. Wedge bonding processes usually utilize ultrasonic energy and pressure to create a bond between the bonding wire, which is usually a thick wire, and the bond pad. Wedge bonding processes are generally low temperature processes which are performed at room temperature. Usually Al-wires (aluminum wires) are used for wedge bonding processes. Bonding wires including other materials such as Cu (copper), for example, are generally preferred with respect to reliability and performance. However, Cu-wires are generally harder than Al-wires. The bond pad usually needs to include other materials than aluminum when using Cu-wires. That is because the hardness of aluminum bond pads is generally not sufficient for the comparably hard Cu-wires, therefore, the bond pad should include a material that is harder than aluminum. Further, for Cu-wires an increased ultrasonic power has to be provided as compared to wedge bonding processes using Al-wires. Even further, the time for performing the wedge bonding process is increased and the Cu-wire needs to be pressed on the bond pad with a larger strength as compared to a wedge bond process using Al-wires and Al-bond pads. This increased strength (or force) may result in severe damages of the bond pad material, for example.

Document US 2005/150932 A1 discloses a wire-bonding process and to a process for producing a bonded joint. A bonding location is heated by means of a laser beam originating from a laser, the arrangement comprising an ultrasonic wedge-wedge bonding unit with a bonding needle, a copper or aluminum bonding wire guide, and a copper or aluminum wire for an ultrasonic wedge-wedge bonding process, and at least one of the bonding locations having a hard-metal coating.

Document "High-Temperature thick Al wire bonding technology for high-power modules" by Komiyama et al. in Japanese Journal of Applied Physics, Japan Society of Applied Physics, JP, vol. 41, no. 8, part 01, 1 August 2020, pages 5030-5033 discloses a high-temperature thick Al wire bonding technology comprising bonding 300-µm-diameter Al wires to Al pads on an insulated gate bipolar transistor chip at varying substrate temperatures and ultrasonic powers.

Document US 2015/243534 A1 discloses a bonding apparatus and a method of bonding copper bond wires to bond pads on an integrated circuit devices attached to a substrate. A heater block heats the devices and substrate prior to and during wire bonding. A clamp presses the substrate down onto the heater block during wire bonding and thereby forms a region of the substrate isolated from the remainder of the substrate. A bonder head creates ball bonds as it attaches one end of the bond wires to the bond pads on the devices within the isolated region. The bonder head also attaches the other end of the bond wires to substrate pads adjacent the devices being wire bonded. To prevent corrosion of the ball bonds, a gas source floods the substrate and the attached devices that have not yet wire bonded with a purge gas while the heater block heats the substrate and the attached devices.

There is a need for an improved method which provides a stable and durable connection between a bonding wire and the element that is to be electrically contacted.

### SUMMARY

A method includes heating a first electrically conductive layer that is to be electrically contacted, and that is arranged on a first element, and pressing a first end of a bonding wire on the first electrically conductive layer by exerting pressure to the first end of the bonding wire, and further by exposing the first end of the bonding wire to ultrasonic energy, thereby deforming the first end of the bonding wire and creating a permanent substance-to-substance bond between the first end of the bonding wire and the first electrically conductive layer. The bonding wire either comprises a rounded cross section with a diameter of at least 125 µm or a rectangular cross section with a first width of at least 500µm and a first height of at least 50µm. The first layer has a thickness of at least 50µm.

An arrangement is described for establishing a permanent bond connection between a bonding wire and a first electrically conductive surface of a first element. The arrangement includes a bonding chamber, a bonding device arranged within the bonding chamber, wherein the bonding device is configured to press a first end of the bonding wire on the first electrically conductive surface, and a heating device, configured to heat the first layer and the first end of the bonding wire. The arrangement is configured to establish a connection between the first surface having a thickness of at least 50µm, and a bonding wire, the bonding wire comprising either a rounded cross section with a diameter of at least 125µm, or a rectangular cross section with a first width of at least 500µm and a first height of at least 50µm.

The invention may be better understood with reference to the following drawings and the description. The components in the figures are not necessarily to scale, emphasis is instead being placed upon illustrating the principles of the invention. Moreover, in the figures, like referenced numerals designate corresponding parts throughout the different views.

### BRIEF DESCRIPTION OF THE DRAWINGS

Figures 1 to 4 schematically illustrate several steps of a typical wedge bond process.
Figure 5, including Figures 5A and 5B, schematically illustrates different cross sections of a bonding wire.
Figure 6 schematically illustrates an exemplary method for providing a bond connection.
Figure 7 schematically illustrates another exemplary method for providing a bond connection.
Figure 8 schematically illustrates another exemplary method for providing a bond connection.
Figure 9 schematically illustrates another exemplary method for providing a bond connection.
Figure 10 schematically illustrates an exemplary bonding device.
Figure 11 schematically illustrates the commingling of the materials of different bonding partners.
Figure 12 schematically illustrates a cross-sectional view of an exemplary arrangement for providing a bond connection.
Figure 13 schematically illustrates a cross-sectional view of another exemplary arrangement for providing a bond connection.
Figure 14, including Figures 14A and 14B, schematically illustrates a top view on the opening provided in the chamber illustrated in Figure 13.
Figure 15 schematically illustrates a cross-sectional view of another exemplary arrangement for providing a bond connection.
Figure 16 schematically illustrates a cross-sectional view of another exemplary arrangement for providing a bond connection.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or be included in a semiconductor chip. A semiconductor body has electrically connecting pads and includes at least one semiconductor element with electrodes.

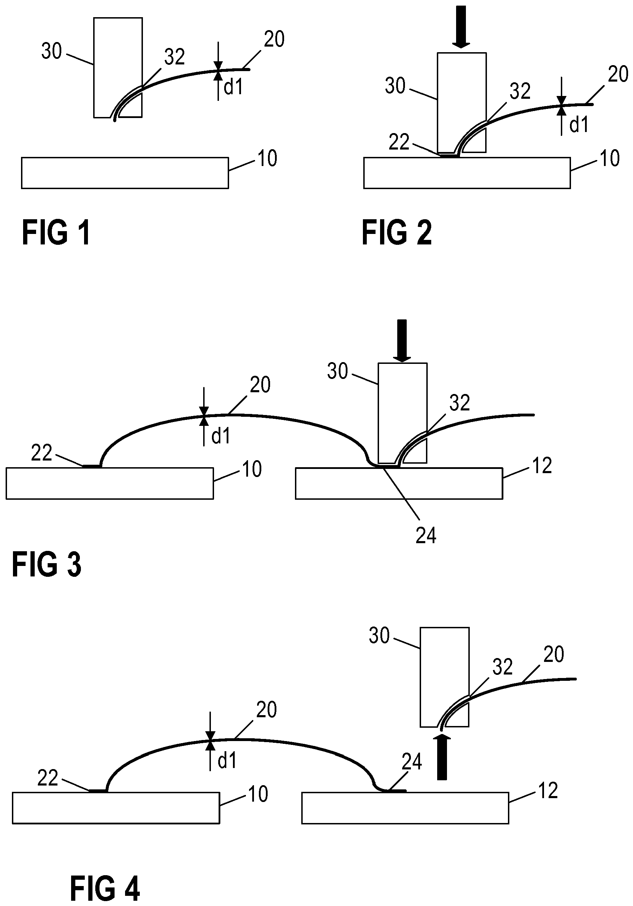

Referring to Figures 1 to 4, the general principle of a method for establishing a connection (a bond) between a bonding wire 20 and an element 10 that is to be electrically contacted is schematically illustrated. Generally, different bonding methods are known such as the so-called ball bonding, ball-wedge bonding, wedge bonding, or wedge-wedge bonding, for example. The present example refers to a wedge-wedge bonding method.

Figure 1 schematically illustrates a first element 10 that is to be electrically contacted, and a bonding device 30. The first element 10 may be or may comprise a semiconductor body, for example. In power semiconductor module arrangements usually one or more semiconductor bodies are arranged on a semiconductor substrate. Each of the semiconductor bodies arranged on a semiconductor substrate may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element. One or more semiconductor bodies may form a semiconductor arrangement on the semiconductor substrate. This, however, is only an example. The first element 10 may be any element, e.g., of a power semiconductor module arrangement, that is to be electrically contacted with a bonding wire 20.

According to another example, the first element 10 may be a semiconductor substrate. A semiconductor substrate usually includes a dielectric insulation layer, a (structured) first metallization layer attached to the dielectric insulation layer, and a second (structured) metallization layer attached to the dielectric insulation layer. The dielectric insulation layer is disposed between the first and second metallization layers. Each of the first and second metallization layers may consist of or include one of the following materials: copper; a copper alloy; aluminum; an aluminum alloy; any other metal or alloy that remains solid during the operation of the power semiconductor module arrangement. A semiconductor substrate may be a ceramic substrate, that is, a substrate in which the dielectric insulation layer is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer may consist of or include one of the following materials: Al₂O₃, AIN, BN, or Si3N₄. For instance, a substrate may, e.g., be a Direct Copper Bonding (DCB) substrate, a Direct Aluminum Bonding (DAB) substrate, or an Active Metal Brazing (AMB) substrate. A substrate may also be a conventional printed circuit board (PCB) having a non-ceramic dielectric insulation layer. For instance, a non-ceramic dielectric insulation layer may consist of or include a cured resin. The bonding wire 20 may be permanently connected to one of the first and second metallization layers, e.g., to the first metallization layer.

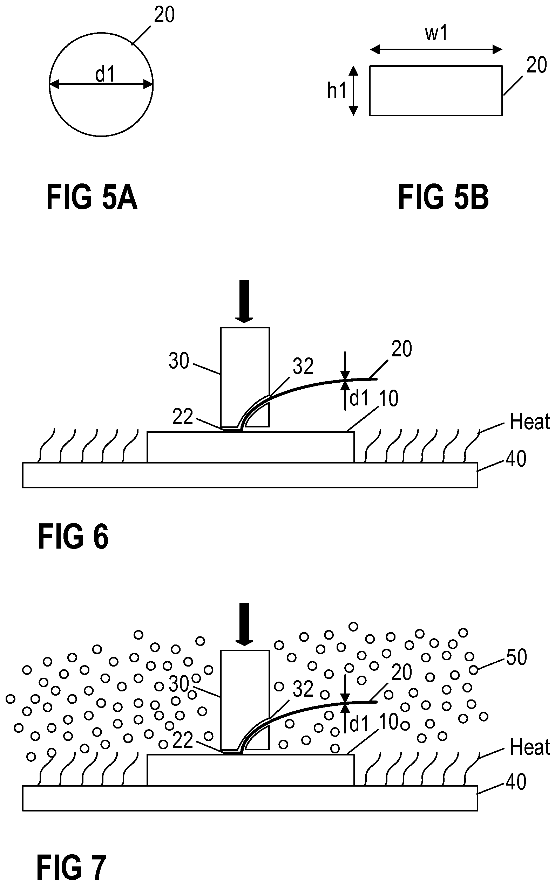

A bonding wire 20 is inserted into the bonding device 30. The bonding wire 20 may be any suitable electrically conductive wire, e.g., a metal wire. For wedge-wedge bonding methods, usually thick bonding wires are used. Thick bonding wire in this context refers to a bonding wire 20 having a rounded cross section (see Figure 5A) with a diameter d1 of at least 125µm, or to a bonding wire 20 having a rectangular cross-section (see Figure 5B) with a width w1 of at least 500µm and a height h1 of at least 50µm, for example. For the purpose of explanation it should be mentioned that in ball bonding methods, one end of the bonding wire is melted using high-voltage discharge, thereby forming a ball of soft material at one end of the bonding wire. This ball is then welded to the element that is to be electrically contacted. As compared to ball bonding methods, the bonding wire 20 in wedge bonding methods as described herein is not melted by use of high-voltage discharge to make it softer before pressing the bonding wire 20 to the first element 10.

The bonding device 30 comprises a guiding element 32. The guiding element is configured to accommodate the bonding wire 20 or, in other words, the bonding wire 20 may be inserted into the guiding element 32. The bonding device 30 is configured to position the bonding wire 20 at a desired position with respect to the first element 10. The guiding element 32 may include a channel, for example. As is exemplarily illustrated in Figure 2, a first end 22 of the bonding wire 20 may protrude from the guiding element 32. When lowering the bonding device 30 onto the first element 10, the first end 22 of the bonding wire 20 which protrudes from the guiding element 32 is arranged between the bonding device 30 and the first element 10. The first end 22 of the bonding wire 20 protrudes from the guiding element 32 at a desired position of the bonding device 30. Therefore, by positioning the bonding device 30 with respect to the first element 10, the first end 22 of the bonding wire 20 may also be precisely positioned with respect to the first element 10. The first end 22 of the bonding wire 20 is then pressed onto the first element 10 by applying a certain pressure with the bonding device 30. This pressure that is applied by the bonding device 30 is exemplarily illustrated by means of a bold arrow in Figure 2. As has been described before, no ball is formed at the first end 22 of the bonding wire 20 before pressing the first end 22 to the first element 10. When pressing the first end 22 on the first element 10 and applying a force to the first end 22, at least the first end 22 may additionally be exposed to ultrasonic energy, thereby deforming the first end 22 of the bonding wire 20 while pressing it to the first element 10 and creating a permanent substance-to-substance bond between the first end 22 of the bonding wire 20 and the first element 10. Additionally, the first element 10 may also be exposed, at least partly, to ultrasonic energy.

As is exemplarily illustrated in Figure 3, the first element 10 may be electrically connected to a second element 12 via the bonding wire 20. A second end 24 of the bonding wire 20 may be connected (bonded) to the second element 12 in essentially the same way as has been described with respect to the first element 10 and the first end 22 of the bonding wire 20 before. The bonding wire 20 may be a continuous bonding wire 20 which is cut off at a desired location, thereby forming the second end 24, as is exemplarily illustrated in Figure 4. The bonding wire 20 may be cut off after establishing the connection with the second element 12, when lifting the bonding device 30 from the second element 12, as is exemplarily illustrated by the bold arrow in Figure 4. The second element 12 may be another semiconductor body or a semiconductor substrate, for example.

Usually, aluminum (Al) wires are used for wedge bonding processes. However, the use of Al-wires has several disadvantages. Other materials such as Copper (Cu), for example, provide better characteristics with regard to reliability and performance as compared to Al-wires. Copper, however, is generally harder than aluminum. When using Cu-wires, therefore, more pressure needs to be applied to the first end 22 (or second end 24) of a Cu-wire as compared to Al-wires. Pressing the comparably hard Cu-wire on the first element 10 (or the second element 12) may lead to damages of the first element 10 (or the second element12). For example, the first element 10 may comprise an electrically conductive layer (e.g., bond pad, not illustrated in Figures 1 to 4). Such an electrically conductive layer may comprise an electrically conducting material such as a metal, or a metal alloy, for example. If a Cu-wire is used, the electrically conductive layer often also comprises Copper. The first end 22 of the bonding wire 20 may be pressed on such an electrically conductive layer. If the first end 22 of the bonding wire 20 is pressed on the electrically conductive layer with relatively high pressure, however, the electrically conductive layer may be damaged. Therefore, generally ball bonding processes are used instead of wedge bonding processes when bonding Cu-wires.

Figure 6 schematically illustrates an exemplary embodiment of a wedge-wedge bonding method that may be used for bonding Cu-wires. The bonding wire 20 that is exemplarily illustrated in Figure 6 may consist of or may include copper or a copper alloy, for example. The bonding wire 20 may be a thick bonding wire having a diameter d1 of at least 125µm, or at least 200µm, and at most 600µm, for example. According to one example, the diameter d1 is between 125µm and 600µm. If the bonding wire 20 has a rectangular cross section instead of a round cross section, the bonding wire 20 may have a width w1 of at least 500µm, at least 700µm, at least 1000µm, or at least 2000µm, and at most 3000µm, for example. According to one example, the width w1 is between 500µm and 3000µm. The bonding wire 20 having a rectangular cross section may have a height h1 of at least 50µm, at least 100µm, or at least 150µm, and at most 400µm, for example. According to one example, the height h1 is between 50µm and 400µm.

As is schematically illustrated in Figure 6, the first element 10 and the first end 22 of the bonding wire 20 are heated while bonding the bonding wire 20 to the first element 10, that is, while applying pressure to the first end 22 of the bonding wire 20 and while further exposing the first end 22 of the bonding wire to ultrasonic energy. For example, the first end 22 of the bonding wire 20 may be heated via the first element 10. That is, heat is applied to the first element 10 and is subsequently transferred to the first end 22 of the bonding wire 20. For example, the first element 10 may be arranged on a heating device 40, as schematically illustrated in Figure 6. The heating device 40 may be configured to heat the first element 10 and further to radiate heat to the surroundings of the element 10 and of the bonding wire 20. For example, if the first element 10 and the bonding wire 20 are arranged in a bonding chamber (not illustrated in Figure 6), the inside of the bonding chamber may be heated by the heating device 40. Heating the first element 10 (and an optional electrically conductive layer arranged on the first element 10) and the first end 22 of the bonding wire 20 supports the bonding process. When heated, the components such as the bonding wire 20 or an electrically conductive layer provided on the first element 10, for example, may be formed or reshaped a lot easier than without heating. Heating the components that are to be bonded together further increases the friction value and, therefore, the energy transmission. The solidity (yield strength/tensile strength) of the components decreases with increasing temperature. The energy that is required for forming the bond between the bonding wire 20 and the first element 10 depends on the temperature of the components. If the temperature increases, the energy required for the bonding process decreases. The total energy that is required to form the bond between the bonding wire 20 and the element 10 is generally made up of normal force and ultrasonic energy.

However, the probably most important advantage of applying heat to the components is the reduction of mechanical stress affecting the first element 10 (or the electrically conductive layer arranged on the first element 10). When pressing the bonding wire 20 on an electrically conductive layer, the materials of the bonding wire 20 and the electrically conductive layer commingle to a certain degree. A reduced mechanical stress results in a lower commingling of the materials of the different components. It is generally preferable that the materials commingle only to a comparably low degree. The reliability and the quality of the bond connection, however, is at least the same as for conventional wedge-wedge bonding processes without heating, if not better.

The bonding process may be performed in an ambient air environment. As is exemplarily illustrated in Figure 7, the wedge-wedge bonding process that has been described with respect to Figure 6 above, may also be carried out in a protective atmosphere (inert atmosphere), for example. That is, an inert protective gas 50 may be provided. The inert protective gas 50 may surround the bonding device 30, the bonding wire 20 as well as the first element 10. The inert protective gas 50 further assists the bonding process and further enhances the advantages that have been discussed above. Further, the inert protective gas 50 functions as protection against oxidation of the metallic components. Heating the metallic components such as the bonding wire 20 and the electrically conductive layer may result in an oxidation of the surfaces of the metallic components if an oxidation protection is not provided. An oxidation of the surfaces of the bonding partners reduces the reliability of the bond that is formed between the bonding partners. At worst, an oxidation of the surfaces of the bonding partners may result in unwanted lift offs of the bonding wires.

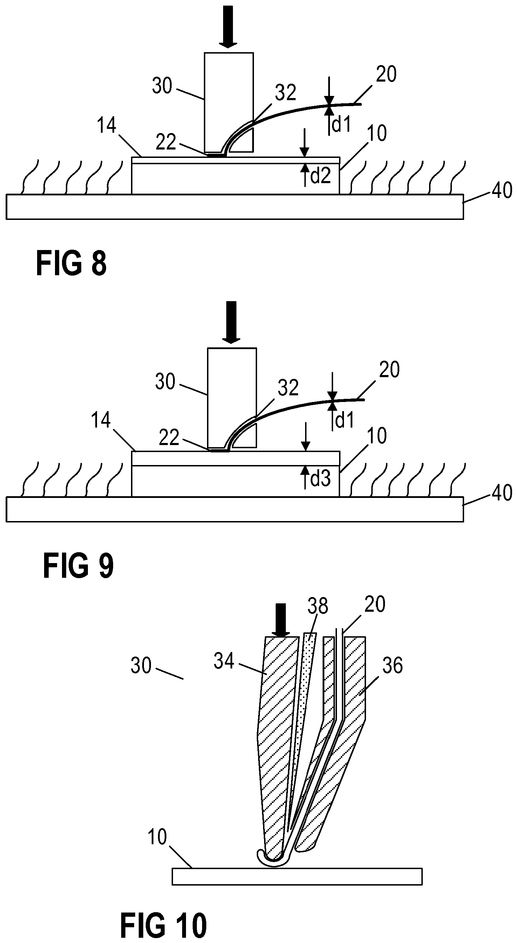

Performing the bonding process in an inert gas atmosphere, however, is only an example. Instead of an inert gas, a reducing protection gas may be provided. A reducing protection gas may comprise, e.g., Ar, SF₆ or H2, for example. Alternatively, any other suitable gases may be provided. Both, an inert gas and a reducing protective gas, may alter the tribological stress exerted on the bonding partners. In particular, such gases may positively alter the tribological stress such that the abrasion of the bonding partners may be reduced. As is exemplarily illustrated in Figure 8 and as has been explained above, the first element 10 may comprise a first layer 14 of electrically conducting material. The first layer 14 may function as a bond pad and the bonding wire 20 may be permanently connected to the first layer 14. As has been described before, the first layer 14 may comprise a metal such as Copper, for example. The first layer 14 may comprise the same material as the bonding wire 20 and may have a thickness d2 of less than 25µm and at least 5µm (not claimed). The first layer 14 may completely cover a surface of the first element, as is exemplarily illustrated in Figure 8. This, however, is only an example. It is also possible that the first layer 14 only partly covers one of the surfaces of the first element 10.

As has been described above, the material of the bonding wire 20 and the material of the first layer 14 may at least partly commingle during the bonding process, because of the hardness of the thick Cu-wire. By heating the first layer 14 and the bonding wire 20, e.g., with the heating arrangement that has been described with respect to Figure 6 above, the commingling of the materials of the first layer 14 and the bonding wire 20 may be reduced. Even for first layers 14 having a thickness d2 of at least 5µm and less than 25µm (not claimed), at least 10% of the thickness d2 below the first end 22 of the bonding wire 20 may remain intact after bonding the bonding wire 20 to the first layer 14. Remaining intact in this context means that the material does not commingle with the material of the bonding wire 20. This reduced commingling may be further supported by providing a protective gas atmosphere, as has been described with respect to Figure 7 above. The temperature of the first layer 14 and the bonding wire 20 may be, e.g., at least 80°C, at least 100°C, at least 150°C or at least 200°C, and at most 250°C.

According to an even further example, the bonding process is performed in a vacuum. For example, the bonding partners (e.g., first element 10, bonding wire 20) and the bonding device 30 may be arranged in a vacuum chamber while performing the bonding process. The vacuum, together with the increased temperature, has a similarly positive effect as the inert gas and the reduced protective gas that have been described before.

According to an even further example, the thickness of the first layer 14 may be increased as compared to the arrangement that has been described with respect to Figure 8 before. This is exemplarily illustrated in Figure 9. The thickness d3 of the first layer 14 may be greater than 50µm, for example. If the thickness d2, d3 of the first layer 14 is increased, a larger percentage of the material of the first layer 14 that is arranged below the first end 22 of the bonding wire 20 remains intact after the bonding process. This means that the commingling of the material of the bonding wire 20 and the first layer 14 does not affect the whole thickness d2, d3 of the first layer 14. For example, if the thickness of the first layer 14 is increased to more than 50µm, at least 50% or at least 60% of the thickness d2, d3 below the first end 22 may remain intact. However, it is also possible that more or less of the thickness d2, d3 below the first end 22 remain intact.

The bonding device 30 illustrated in Figures 1 to 9 is only one example. The bonding device 30 may be implemented in any other suitable way. One further possible example is schematically illustrated in Figure 10. As is illustrated in Figure 10, the bonding device 30 may comprise a so-called wedge 34. The wedge 34 is mainly configured to apply a pressure to a bonding wire 20, thereby pressing the bonding wire 20 on the first element 10 to form the bonding connection. The bonding wire 20 may be held in place by a so-called wire guide 36. In particular, the bonding wire 20 may be led through the wire guide 36 and protrude from an opening in the wire guide 36. The wire guide 36 may be positioned in relation to the wedge 34. For example, the wire guide 36 may be permanently coupled to the wedge 34 such that the wire guide 36 and the wedge 34 always perform the same movements and the wire guide 36 is always positioned in the same position with regard to the wedge 34. The bonding device 30 may further comprise a blade 38 for cutting the bonding wire 20, where required. Any other suitable implementations of the bonding device 30 are also possible.

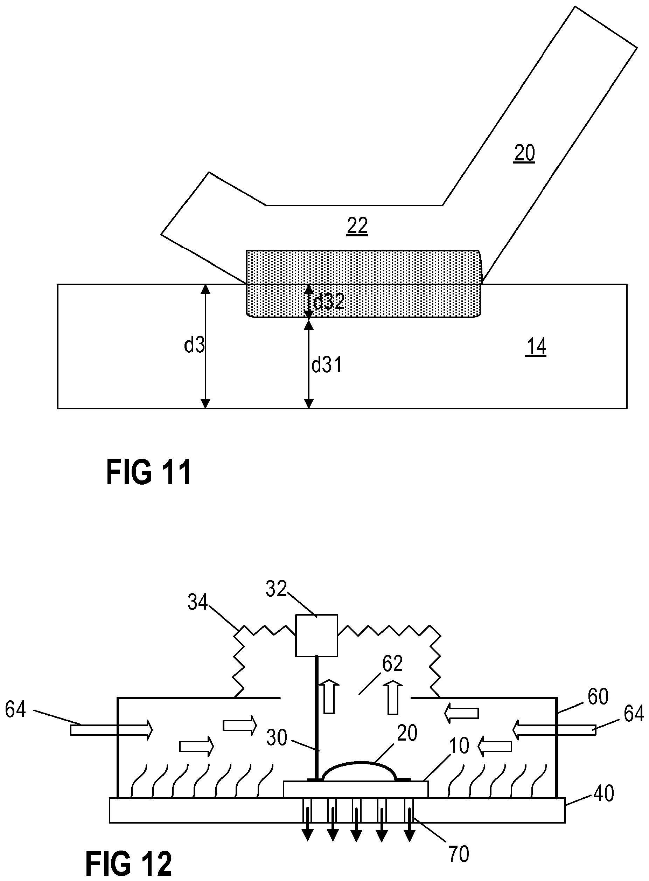

The commingling of the materials of different bonding partners is exemplarily illustrated in Figure 11. Figure 11 illustrates a cross-sectional view of a section of the first layer 14 and a first end 22 of a bonding wire 20 that is bonded to the first layer 14. The first layer has a thickness d3, as has been described with respect to Figure 9 before. The commingling of the materials is indicated with the dotted area. The commingling may occur in the first layer 14 as well as in the bonding wire 20. In the area below the first end 22 of the bonding wire 20, the first layer 14 may be seen as having a first sub-layer including only material of the first layer 14 and a second sub-layer including commingled material (material of the first layer 14 and the bonding wire 20 intermixed). The first sub-layer have a thickness d31 and the second sub-layer may have a thickness d32. As has been described above, the thickness d31 of the first sub-layer may be at least 10%, at least 50% or at least 60% of the thickness d3 of the first layer 14.

According to a further example, the hardness of the first layer 14 may be chosen such that the wear of the first layer 14 is reduced. For example, the hardness of the first layer 14 may be chosen depending on the hardness of the bonding wire 20. The bonding wire 20 may have a first hardness and the first layer 14 may have a second hardness, wherein the second hardness is greater than the first hardness. For example, the second hardness may be ≥150% of the first hardness. A greater hardness of the first layer 14 may be attained by alloying the material of the first layer 14, e.g., the copper of the first layer 14. Increasing the hardness of the first layer 14 with respect to the hardness of the bonding wire 20 reduces the tribological stress on the first layer 14.

According to another example, a greater hardness of the first layer 14 may be attained by adjusting the fine crystalline copper structure of the first layer 14. For example, the grain size of the microstructure within the first layer 14 may be less than the thickness d2, d3 of the first layer 14.

Now referring to Figure 12, an arrangement that may be used to perform a bonding process as has been described with respect to Figures 1 to 9 above is exemplarily illustrated. For example, the arrangement may comprise a bonding chamber 60. The first element 10 may be arranged within the bonding chamber 60. A heating device 40 may form a bottom of the bonding chamber 60. This, however, is only an example. According to another example, the heating device 40 may be arranged within the bonding chamber 60. The first element 10 may be arranged on the bottom of the bonding chamber 60, e.g., on the heating device 60. The bonding device 30 that is configured to receive the bonding wire 20, to position the bonding wire 20 with respect to the first element 10, and to press the bonding wire to the first element 10 is arranged within the bonding chamber 60. The bonding device 30 may be coupled to a control unit 32. The bonding chamber 60 may comprise an opening 62. The bonding device 30 may protrude through the opening 62 to the outside of the bonding chamber 60. The opening 62 may be covered by a flexible cover 34, which may be a sort of bellows, for example. The flexible cover 34 may prevent a significant gas exchange between the inside and the outside of the bonding chamber 60. In this way, an inert gas or a reduced protective gas could be prevented from escaping the bonding chamber 60. Further, the flexible cover 34 which closes the bonding chamber 60 allows to create a vacuum within the bonding chamber 60.

The bonding chamber 60 may comprise one or more gas inlets 64 that are configured to direct a gas such as an inert gas or a reducing protective gas into the bonding chamber 60. The flow of gas inside the chamber 60 is exemplarily illustrated in Figure 12 by bold arrows. The flexible cover 34 may not completely seal the opening 62 of the bonding chamber 60. Therefore, some gas that is led into the chamber 60 though the gas inlets 64 may exit the chamber 60 through the flexible cover 34 or through gaps between the flexible cover 34 and the bonding chamber 60. The control unit 32 may protrude through an opening in the flexible cover 34, thereby closing the opening in the flexible cover 34. The control unit 32 and the bonding device 30 that is connected to the control unit 32 need to be moved in order to position the bonding wire 20 in relation to the first element 10. The flexible cover 34 allows such movements of the control unit 32 and the bonding device 30.

An optional vacuum unit 70 may be arranged in the bottom of the bonding chamber 60. The vacuum unit 70 may be configured to create a vacuum, thereby drawing the first element 10 which is arranged above the vacuum unit 70 towards the bottom of the bonding chamber 60. In this way, the first element 10 may be firmly held in place during the bonding process when comparably large forces are exerted on the first element 10. The first element 10, however, may be held in place in any other suitable way. The bonding chamber 60 mainly functions as a gas cover. However, the bonding chamber 60 may be further configured to keep heat that is generated by the heating device inside a specified volume (inside the bonding chamber 60).

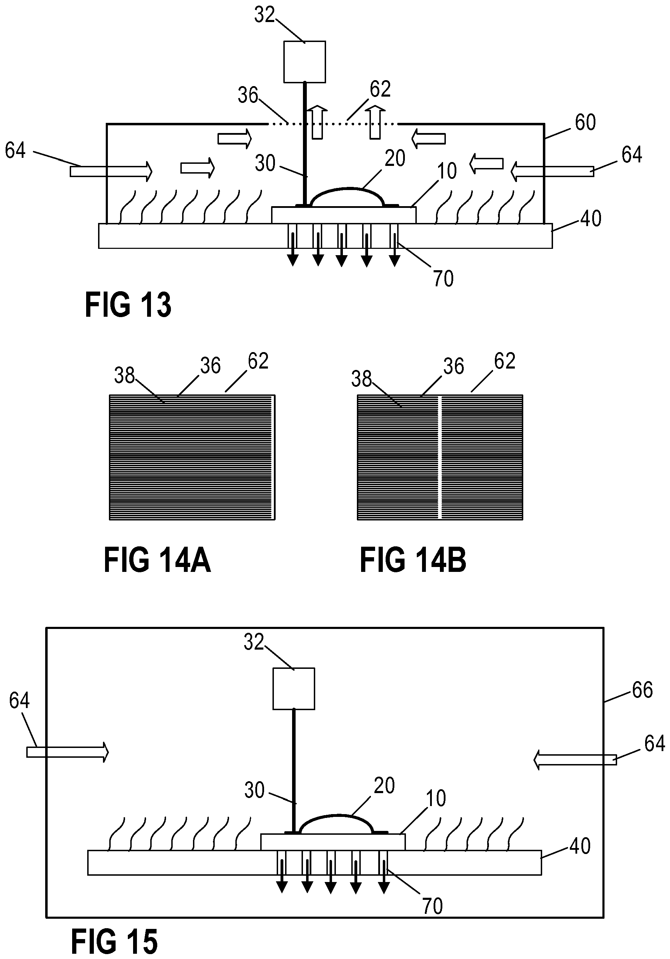

Now referring to Figure 13, according to another example the opening 62 of the bonding chamber 60 may be covered with a brush protection cap 36. Figures 14A and 14B schematically illustrate top views of different implementations of a brush protection cap 36. According to a first example, a multiplicity of bristles 38 protrudes from a first side into the opening 62, thereby essentially covering the opening. A brush protection cap 36 generally does not provide a gas tight cover for the opening 62. Therefore, gas that is led into the chamber 60 may exit the chamber 60 though openings between the bristles 38 of the brush protection cap36. This is schematically illustrated with bold arrows in Figure 13. The control unit 32 may be arranged outside the bonding chamber 60. The bonding device 30 may protrude through the bristles 38 into the bonding chamber 60. The flexible bristles 38 allow the bonding device 30 to move in order to position the bonding wire 20. As is schematically illustrated in Figure 14B, bristles 38 may protrude into the opening 62 from two different sides. In the example of Figure 14B, the bristles do not overlap. This, however, is only an example. According to another example, the bristles 38 protruding from different sides of the opening 62 may overlap. Further, the bristles 38 may be arranged in any other suitable way, thereby covering the opening 62 and allowing a movement of the bonding device 30.

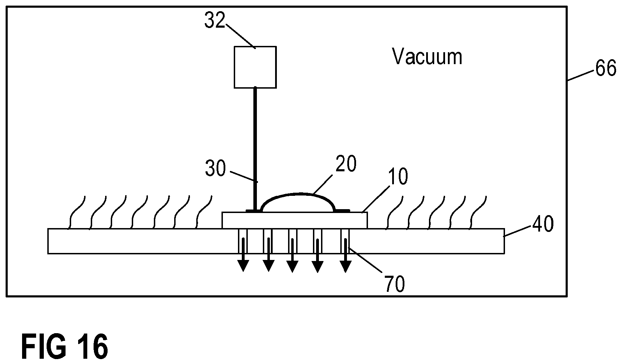

According to another example which is exemplarily illustrated in Figure 15, the arrangement is arranged within a closed bonding chamber 66. This means that the bonding device 30 and the control unit 32 are also completely arranged within the closed chamber 66. This allows for providing a bonding chamber 66 which is more leakproof to gases than the arrangements illustrated in Figures 12 and 13 above. The closed chamber 66 may be filled with gas through gas inlets 64. According to another example, a vacuum may be generated within the closed chamber 66, as is exemplarily illustrated in Figure 16. The main components of the arrangements illustrated in Figures 12, 13, 14, 15 and 16 are identical or similar to each other. Therefore, in the foregoing description focus is laid on the differences between the different embodiments.

## Claims

1. A method comprising:
heating a first electrically conductive layer (14) that is to be electrically contacted, and that is arranged on a first element (10); and
pressing a first end (22) of a bonding wire (20) on the first electrically conductive layer (14) by exerting pressure to the first end (22) of the bonding wire (20), and further by exposing the first end (22) of the bonding wire (20) to ultrasonic energy, thereby deforming the first end (22) of the bonding wire (20) and creating a permanent substance-to-substance bond between the first end (22) of the bonding wire (20) and the first electrically conductive layer (14); wherein
the bonding wire (20) either comprises a rounded cross section with a diameter (d1) of at least 125µm or a rectangular cross section with a first width (w1) of at least 500µm and a first height (h1) of at least 50µm, and
the first layer (14) has a thickness (d2, d3) of at least 50µm.

2. The method of claim 1, further comprising
establishing a wedge-wedge bond connection between the bonding wire (20) and the first layer (14).

3. The method of claim 1 or 2, further comprising heating the first electrically conductive layer (14) to a temperature of between 80°C and 250°C, between 100°C and 250°C, or between 150°C and 250°C.

4. The method of any of claims 1 to 3, further comprising
providing an inert gas, a reducing protective gas, or a vacuum in the surroundings of the first layer (14) and the first end (22) of the bonding wire (20).

5. The method of any of claims 1 to 4, wherein the bonding wire (20) has a first hardness and the first layer (14) has a second hardness, wherein the second hardness is greater than the first hardness.

6. The method of claim 5, wherein the second hardness is ≥150% of the first hardness.

7. The method of claim 5 or 6, wherein the bonding wire (20) comprises a first material, and the first layer (14) comprises an alloy of the first material.

8. The method of any of the preceding claims, wherein the bonding wire (20) comprises copper.

9. The method of any of the preceding claims, further comprising
inserting the bonding wire (20) into a guiding element (32, 36) of a bonding device (30), wherein the bonding device (30) is configured to position the first end (22) of the bonding wire (20) at a desired position with respect to the first element (10), and to press the first end (22) of the bonding wire (20) on the first element (10) at the desired position.

10. An arrangement for establishing a permanent bond connection between a bonding wire (20) and a first electrically conductive surface (14) of a first element (10), the arrangement comprising:
a bonding chamber (60, 66);
a bonding device (30) arranged within the bonding chamber (60, 66), wherein the bonding device (30) is configured to press a first end (22) of the bonding wire (20) on the first electrically conductive surface (14); and
a heating device (40), configured to heat the first layer (14) and the first end (22) of the bonding wire (20), wherein
the arrangement is configured to establish a connection between the first surface (14) having a thickness (d2, d3) of at least 50µm, and a bonding wire (20), the bonding wire (20) comprising either a rounded cross section with a diameter (d1) of at least 125µm, or a rectangular cross section with a first width (w1) of at least 500µm and a first height (h1) of at least 50µm.

11. The arrangement of claim 10, wherein the bonding device (30) is further configured to establishing a wedge-wedge bond connection between the bonding wire (20) and the first layer (14).

12. The arrangement of claim 10 or 11, wherein the bonding chamber (60) comprises an opening (62) and the bonding device (30) protrudes through the opening (30).

13. The arrangement of claim 12, further comprising a cover that is configured to cover the opening (62) of the bonding chamber (60), wherein the cover comprises
a flexible cover (34) configured to prevent a significant gas exchange between the inside and the outside of the bonding chamber (60), wherein the bonding device (30) is coupled to the flexible cover (34) via a control unit (32), and wherein the flexible cover (34) allows a movement of the bonding device (30); or
a brush protection cap (36) configured to cover the opening (62), wherein the bonding device (30) protrudes through the brush protection cap (36), and wherein the brush protection cap (36) allows a movement of the bonding device (30).

14. The arrangement of any of claims 10 to 13, wherein the bonding chamber (60, 66) further comprises at least one gas inlet (64) configured to direct an inert gas or a reducing protective gas into the bonding chamber (60).

## Patentansprüche

1. Verfahren, umfassend:
Erhitzen einer ersten elektrisch leitenden Schicht (14), die elektrisch kontaktiert werden soll und die auf einem ersten Element (10) angeordnet ist; und
Pressen eines ersten Endes (22) eines Bonddrahtes (20) auf die erste elektrisch leitende Schicht (14) durch Ausüben eines Drucks auf das erste Ende (22) des Bonddrahtes (20) und ferner durch Aussetzen des ersten Endes (22) des Bonddrahtes (20) einer Ultraschallenergie, wodurch das erste Ende (22) des Bonddrahtes (20) verformt wird und eine dauerhafte stoffschlüssige Verbindung zwischen dem ersten Ende (22) des Bonddrahtes (20) und der ersten elektrisch leitenden Schicht (14) erzeugt wird; wobei
der Bonddraht (20) entweder einen abgerundeten Querschnitt mit einem Durchmesser (d1) von mindestens 125 µm oder einen rechteckigen Querschnitt mit einer ersten Breite (w1) von mindestens 500 µm und einer ersten Höhe (h1) von mindestens 50 µm umfasst, und
die erste Schicht (14) eine Dicke (d2, d3) von mindestens 50 µm aufweist.

2. Verfahren nach Anspruch 1, ferner umfassend:
Herstellen einer Keil-Bondverbindung zwischen dem Bonddraht (20) und der ersten Schicht (14).

3. Verfahren nach Anspruch 1 oder 2, ferner umfassend das Erhitzen der ersten elektrisch leitenden Schicht (14) auf eine Temperatur zwischen 80 °C und 250 °C, zwischen 100 °C und 250 °C oder zwischen 150 °C und 250 °C.

4. Verfahren nach einem der Ansprüche 1 bis 3, ferner umfassend:
Bereitstellen eines Inertgases, eines reduzierenden Schutzgases oder eines Vakuums in der Umgebung der ersten Schicht (14) und des ersten Endes (22) des Bonddrahtes (20).

5. Verfahren nach einem der Ansprüche 1 bis 4, wobei der Bonddraht (20) eine erste Härte und die erste Schicht (14) eine zweite Härte aufweist, wobei die zweite Härte größer als die erste Härte ist.

6. Verfahren nach Anspruch 5, wobei die zweite Härte ≥150 % der ersten Härte beträgt.

7. Verfahren nach Anspruch 5 oder 6, wobei der Bonddraht (20) ein erstes Material umfasst und die erste Schicht (14) eine Legierung des ersten Materials umfasst.

8. Verfahren nach einem der vorhergehenden Ansprüche, wobei der Bonddraht (20) Kupfer umfasst.

9. Verfahren nach einem der vorhergehenden Ansprüche, ferner umfassend:
Einführen des Bonddrahtes (20) in ein Führungselement (32, 36) einer Bondvorrichtung (30), wobei die Bondvorrichtung (30) dazu ausgelegt ist, das erste Ende (22) des Bonddrahtes (20) an einer Sollposition in Bezug auf das erste Element (10) zu positionieren und das erste Ende (22) des Bonddrahtes (20) an der Sollposition auf das erste Element (10) zu pressen.

10. Anordnung zum Herstellen einer permanenten Bondverbindung zwischen einem Bonddraht (20) und einer ersten elektrisch leitenden Oberfläche (14) eines ersten Elements (10), wobei die Anordnung umfasst:
eine Bondkammer (60, 66);
eine Bondvorrichtung (30), die innerhalb der Bondkammer (60, 66) angeordnet ist, wobei die Bondvorrichtung (30) dazu ausgelegt ist, ein erstes Ende (22) des Bonddrahtes (20) auf die erste elektrisch leitende Oberfläche (14) zu pressen; und
eine Heizvorrichtung (40), die dazu ausgelegt ist, die erste Schicht (14) und das erste Ende (22) des Bonddrahtes (20) zu erhitzen, wobei die Anordnung dazu ausgelegt ist, eine Verbindung zwischen der ersten Oberfläche (14) mit einer Dicke (d2, d3) von mindestens 50 µm und einem Bonddraht (20) herzustellen, wobei der Bonddraht (20) entweder einen runden Querschnitt mit einem Durchmesser (d1) von mindestens 125 µm oder einen rechteckigen Querschnitt mit einer ersten Breite (w1) von mindestens 500 µm und einer ersten Höhe (h1) von mindestens 50 µm umfasst

11. Anordnung nach Anspruch 10, wobei die Bondvorrichtung (30) ferner dazu ausgelegt ist, eine Keil-Bondverbindung zwischen dem Bonddraht (20) und der ersten Schicht (14) herzustellen.

12. Anordnung nach Anspruch 10 oder 11, wobei die Bondkammer (60) eine Öffnung (62) umfasst und die Bondvorrichtung (30) durch die Öffnung (30) ragt.

13. Anordnung nach Anspruch 12, ferner umfassend eine Abdeckung, die dazu ausgelegt ist, die Öffnung (62) der Bondkammer (60) abzudecken, wobei die Abdeckung umfasst:
eine flexible Abdeckung (34), die dazu ausgelegt ist, einen signifikanten Gasaustausch zwischen der Innenseite und der Außenseite der Bondkammer (60) zu verhindern, wobei die Bondvorrichtung (30) über eine Steuereinheit (32) mit der flexiblen Abdeckung (34) gekoppelt ist und wobei die flexible Abdeckung (34) eine Bewegung der Bondvorrichtung (30) ermöglicht; oder
eine Bürstenschutzkappe (36), die dazu ausgelegt ist, die Öffnung (62) abzudecken, wobei die Bondvorrichtung (30) durch die Bürstenschutzkappe (36) hindurchragt und wobei die Bürstenschutzkappe (36) eine Bewegung der Bondvorrichtung (30) ermöglicht.

14. Anordnung nach einem der Ansprüche 10 bis 13, wobei die Bondkammer (60, 66) ferner mindestens einen Gaseinlass (64) umfasst, der dazu ausgelegt ist, ein Inertgas oder ein reduzierendes Schutzgas in die Bondkammer (60) zu leiten.

## Revendications

1. Procédé comprenant :
chauffer une première couche (14) conductrice de l'électricité, qui doit être mise en contact électriquement et qui est disposée sur un premier élément (10) ; et
presser un premier bout (22) d'un fil (20) de liaison sur la première couche (14) conductrice de l'électricité en appliquant une pression au premier bout (22) du fil (20) de liaison, et en exposant en outre le premier bout (22) du fil (20) de liaison à de l'énergie ultrasonore, en déformant ainsi le premier bout (22) du fil (20) de liaison et en créant une liaison permanente de substance à substance entre le premier bout (22) du fil (20) de liaison et la première couche (14) conductrice de l'électricité ; dans lequel
le fil (20) de liaison comprend ou bien une section transversale arrondie d'un diamètre (d1) d'au moins 125 µm ou bien une section transversale rectangulaire d'une première largeur (w1) d'au moins 500 µm et d'une première hauteur (h1) d'au moins 50 µm, et
la première couche (14) a une épaisseur (d2, d3) d'au moins 50 µm.

2. Procédé suivant la revendication 1, comprenant en outre :
établir une connexion par liaison coin-coin entre le fil (20) de liaison et la première couche (14).

3. Procédé suivant la revendication 1 ou 2, comprenant en outre :
porter la première couche (14) conductrice de l'électricité à une température comprise entre 80°C et 250°C, entre 100°C et 250°C, ou entre 150°C et 250°C.

4. Procédé suivant l'une quelconque des revendications 1 à 3, comprenant en outre :
prévoir un gaz inerte, un gaz de protection réducteur, ou un vide dans l'environnement de la première couche (14) et du premier bout (22) du fil (20) de liaison.

5. Procédé suivant l'une quelconque des revendications 1 à 4, dans lequel le fil (20) de liaison a une première dureté et la première couche (14) a une deuxième dureté, la deuxième dureté étant plus grande que la première dureté.

6. Procédé suivant la revendication 5, dans lequel la deuxième dureté est ≥ 150 % de la première dureté.

7. Procédé suivant la revendication 5 ou 6, dans lequel le fil (20) de liaison comprend un premier matériau et la première couche (14) comprend un alliage du premier matériau.

8. Procédé suivant l'une quelconque des revendications précédentes, dans lequel le fil (20) de liaison comprend du cuivre.

9. Procédé suivant l'une quelconque des revendications précédentes, comprenant en outre :
insérer le fil (20) de liaison dans un élément (32, 36) de guidage d'un dispositif (30) de liaison, dans lequel le dispositif (30) de liaison est configuré pour mettre le premier bout (22) du fil (20) de liaison en une position souhaitée par rapport au premier élément (10), et pour presser le premier bout (22) du fil (20) de liaison sur le premier élément (10) en la position souhaitée.

10. Agencement pour établir une connexion par liaison permanente entre un fil (20) de liaison et une première surface (14) conductrice de l'électricité d'un premier élément (10), l'agencement comprenant :
une chambre (60, 66) de liaison ;
un dispositif (30) de liaison disposé dans la chambre (60, 66) de liaison, dans lequel le dispositif (30) de liaison est configuré pour presser un premier bout (22) du fil (20) de liaison sur la première surface (14) conductrice de l'électricité ; et
un dispositif (40) de chauffage, configuré pour chauffer la première couche (14) et le premier bout (22) du fil (20) de liaison, dans lequel
l'agencement est configuré pour établir une connexion entre la première surface (14) d'une épaisseur (d2, d3) d'au moins 50 µm et un fil (20) de liaison, le fil (20) de liaison comprenant ou bien une section transversale arrondie d'un diamètre (d1) d'au moins 125 µm, ou bien une section transversale rectangulaire d'une première largeur (w1) d'au moins 50 µm et d'une première hauteur (h1) d'au moins 50 µm.

11. Agencement suivant la revendication 10, dans lequel le dispositif (30) de liaison est configuré en outre pour établir une connexion par liaison coin-coin entre le fil (20) de liaison et la première couche (14).

12. Agencement suivant la revendication 10 ou 11, dans lequel la chambre (60) de liaison comprend une ouverture (62) et le dispositif (30) de liaison fait saillie dans l'ouverture (62).

13. Agencement suivant la revendication 12, comprenant en outre un couvercle, qui est configuré pour recouvrir l'ouverture (62) de la chambre (60) de liaison, dans lequel le couvercle comprend
un couvercle (34) souple configuré pour empêcher un échange significatif de gaz entre l'intérieur et l'extérieur de la chambre (60) de liaison, dans lequel le dispositif (30) de liaison est couplé au couvercle (34) souple par l'intermédiaire d'une unité (32) de commande, et dans lequel le couvercle (34) souple autorise un mouvement du dispositif (30) de liaison ; ou
une coiffe (36) de protection au frottement configurée pour recouvrir l'ouverture (62), dans lequel le dispositif (30) de liaison fait saillie dans la coiffe (36) de protection au frottement, et dans lequel la coiffe (36) de protection au frottement autorise un mouvement du dispositif (30) de liaison.

14. Agencement suivant l'une quelconque des revendications 10 à 13, dans lequel la chambre (60, 66) de liaison comprend en outre au moins une entrée (64) de gaz configurée pour diriger un gaz inerte ou un gaz protecteur réducteur dans la chambre (60) de liaison.
